# EUROPEAN PATENT SPECIFICATION

(11) **EP 4 068 930 B1**
(45) Date of publication and mention of the grant of the patent: **13.03.2024**
(21) Application number: 21306187.2
(22) Date of filing: 31.08.2021
(51) Int. Cl.: H05K 7/20

(54) **A RACK SYSTEM FOR HOUSING AN ELECTRONIC DEVICE**
RACKSYSTEM ZUR AUFNAHME EINER ELEKTRONISCHEN VORRICHTUNG
SYSTÈME DE RAYONNAGE POUR LOGER UN DISPOSITIF ÉLECTRONIQUE

(30) Priority: 01.04.2021 EP 21305427; 30.08.2021 EP 21306172
(43) Date of publication of application: 05.10.2022
(73) Proprietor: OVH, 59100 Roubaix (FR)
(72) Inventor: CHEHADE, Ali, 59283 Moncheaux (FR); MENEBOO, Alexandre Alain Jean-Pierre, 62440 Harnes (FR); BAUCHART, Grégory Francis Louis, 59150 Wattrelos (FR); KLABA, Henryk, 59100 Roubaix (FR)
(74) Representative: BCF Global

(56) References cited:
- WO-A1-2016/076882
- US-A1- 2017 127 565
- US-A1- 2019 090 383
- US-B1- 10 645 841
- US-B1- 10 791 647

## Description

### CROSS-REFERENCE TO RELATED APPLICATIONS

The present patent application claims priority from European Patent Application Number 21305427.3, filed on April 2021.

### TECHNICAL FIELD

The present disclosure generally relates to a rack system and, in particular, to a rack system for housing an electronic device.

### BACKGROUND

Electronic devices, for example servers, memory banks, computer discs, and the like, are conventionally grouped in rack structures. Large data centers and other large computing infrastructures may contain thousands of rack structures supporting thousands or even tens of thousands of electronic devices.

The electronic devices mounted in the rack structures consume a large amount of electric power and generate a significant amount of heat. Cooling needs are important in such rack structures. Some electronic devices, such as processors, generate so much heat that they could fail within seconds in case of a lack of cooling.

Forced air-cooling has been traditionally used to disperse heat generated by the electronic devices mounted in the rack structures. Air-cooling requires the use of powerful fans, the provision of space between the electronic devices for placing heat sinks and for allowing sufficient airflow, and is generally not very efficient.

With further advancements, liquid-cooling technologies, for example using water-cooling, immersion cooling technologies, for example using water and dielectric immersion cooling liquid, are increasingly used to as an efficient and cost-effective solution to preserve safe operating temperatures of the electronic devices mounted in the rack structures.

However, it is to be noted that, for using the immersion cooling technologies, the dielectric immersion cooling liquid to be filled in an immersion case that provides housing to the electronic devices in the rack structure. It is to be noted that typically a good quality dielectric immersion cooling liquid is quite expensive. There are chances that while de-racking the immersion case from the rack structure, the dielectric immersion cooling liquid may spill out of the immersion rack and at least some portion of the dielectric immersion cooling liquid may get wasted in the de-racking process. In addition to the economic loss, spilling dielectric immersion cooling liquid situations may also be detrimental to the environment.

With this said, there is an interest in designing an effective immersion cases for the rack structure that reduces the above-mentioned problem.

The subject matter discussed in the background section should not be assumed to be prior art merely as a result of its mention in the background section. Similarly, a problem mentioned in the background section or associated with the subject matter of the background section should not be assumed to have been previously recognized in the prior art. The subject matter in the background section merely represents different approaches.

US 2017/0127565 A1 discloses cooling apparatuses and methods of fabrication which facilitate immersion-cooling of an electronic component. The cooling apparatus includes a drawer-level enclosure sized to reside within an electronics rack. The drawer-level enclosure includes a compartment which accommodates one or more electronic components to be cooled. A dielectric 20 fluid is disposed within the compartment. The dielectric fluid includes a liquid dielectric which at least partially immerses the electronic component within the compartment. A hinged, liquid-cooled heat sink is also disposed within the compartment of the enclosure. The heat sink operatively facilitates cooling the one or more electronic components via the dielectric fluid within the compartment, and is rotatable between an operational position overlying the electronic component, and a service position which allows access to the electronic component.

WO 2016/076882 A1 discloses a system including a cooling rack for servers, a first enclosure, and a second enclosure. The first enclosure can be coupled to the cooling rack for servers and houses electronics. The second enclosure can be coupled to the cooling rack for servers beneath the first enclosure with a minimal sliding clearance in between the two enclosures. The second enclosure also holds an electronics cartridge and connects to the cooling rack for servers via a slide that enables the second enclosure to slide out from under the first enclosure so that the electronics cartridge can be removed from a top of the enclosure. Further, the second enclosure may contain a fluid to immerse components and absorb heat from the electronics cartridge.

US 10,645,841 B1 discloses a cooling device that includes a cooling tank, a support frame, and a rotary shaft. The cooling tank accommodates coolant and an electronic device. The electronic device is immersed in the coolant. The support frame defines an opening in a first side plate and a receiving space communicating with the opening. The cooling tank is received in the receiving space. The cooling tank includes a base plate and a sidewall. The rotary shaft is rotationally mounted to a bottom corner of the cooling tank formed by the base plate and the sidewall. The rotary shaft serves as a rotating axis of the cooling tank to rotate the cooling tank out of the opening.

US 10,791,647 B1 discloses a liquid immersion cooling systems including an immersion tank for housing cooling liquid, and a carrier tray. The carrier tray can include a mounting mechanism to attach one or more electronic components to the carrier tray, one or more handles, and one or more extendable sliders, each having a first connection to the carrier tray and a second connection to the immersion tank. The immersion tank can have an opening that faces upward. In a first position of the one or more extendable sliders, the carrier tray is within the immersion tank, and in a second position of the one or more extendable sliders, the carrier tray is vertically lifted out of the opening of the immersion tank.

US 2019/0090383 A1 describes liquid submersion cooling systems that use a cooling liquid, for example a dielectric cooling liquid, to submersion cool an array of electronic devices. In some variants, rather than using pump pressure to return the cooling liquid back to a cooling liquid reservoir, gravity can be used to return the cooling liquid to a reservoir via a cooling liquid gravity return manifold, and a pump can only be used on the liquid supply side to deliver the cooling liquid to each electronic device.

### SUMMARY

The embodiments of the present disclosure have been developed based on developers' appreciation of the shortcomings associated with the prior art.

In particular such shortcomings may comprise spilling out of the immersion cooling liquid from an immersion case during the de-racking operation of immersion case from a rack structure.

To do so, developers of the present disclosure have devised an immersion case with a drainage opening, such that. prior to de-racking the immersion case from the rack structure, the drainage opening may allow a removal of at least a part of the immersion cooling liquid from the vertically installed immersion case in rack structure. The object of the invention is solved by a rack system according to claim 1. Preferred embodiments are presented in the dependent claims.

### BRIEF DESCRIPTION OF THE FIGURES

Further features and advantages of the present disclosure will become apparent from the following detailed description, taken in combination with the appended drawings, in which:
FIG. 1 illustrates a perspective view of a rack system for housing rack mounted assembly;
FIG. 2 illustrates another perspective view of the rack system;
FIG. 3 illustrates a perspective view of the rack mounted assembly;
FIG. 4 illustrates a process for removing at least a part of a dielectric immersion cooling liuid from an immersion case;
FIGs. 5-9 illustrate perspective views of various non-limiting examples corresponding to the removal of dielectric immersion cooling liquid from an immersion case prior to de-racking of the immersion case from the rack structure;

It is to be understood that throughout the appended drawings and corresponding descriptions, like features are identified by like reference characters. Furthermore, it is also to be understood that the drawings and ensuing descriptions are intended for illustrative purposes only and that such disclosures do not provide a limitation on the scope of the claims. The various drawings are not to scale.

### DETAILED DESCRIPTION

The instant disclosure is directed to address at least some of the deficiencies of the current technology. In particular, the instant disclosure describes a rack system for housing an electronic device.

Unless otherwise defined or indicated by context, all technical and scientific terms used herein have the same meaning as commonly understood by one of ordinary skill in the art to which the described examples appertain to.

In the context of the present specification, unless provided expressly otherwise, the words "first", "second", "third", *etc.* have been used as adjectives only for the purpose of allowing for distinction between the nouns that they modify from one another, and not for the purpose of describing any particular relationship between those nouns. Thus, for example, it should be understood that, the use of the terms "first processor" and "third processor" is not intended to imply any particular order, type, chronology, hierarchy or ranking (for example) of/between the server, nor is their use (by itself) intended to imply that any "second server" must necessarily exist in any given situation. Further, as is discussed herein in other contexts, reference to a "first" element and a "second" element does not preclude the two elements from being the same actual real-world element. Thus, for example, in some instances, a "first" server and a "second" server may be the same software and/or hardware, in other cases they may be different software and/or hardware.

It will be understood that when an element is referred to as being "connected" or "coupled" to another element, it can be directly or indirectly connected or coupled to the other element or intervening elements that may be present. In contrast, when an element is referred to as being "directly connected" or "directly coupled" to another element, there are no intervening elements present. Other words used to describe the relationship between elements should be interpreted in a like fashion (*e.g.,* "between" versus "directly between," "adjacent" versus "directly adjacent," *etc.*)*.*

In the context of the present specification, when an element is referred to as being "associated with" another element, in some examples, the two elements can be directly or indirectly linked, related, connected, coupled, the second element employs the first element, or the like without limiting the scope of present disclosure.

The terminology used herein is only intended to describe particular representative examples and is not intended to be limiting of the present technology. As used herein, the singular forms "a," "an" and "the" are intended to include the plural forms as well, unless the context clearly indicates otherwise. It will be further understood that the terms "comprises" and/or "comprising", when used in this specification, specify the presence of stated features, integers, steps, operations, elements, and/or components, but do not preclude the presence or addition of one or more other features, integers, steps, operations, elements, components, and/or groups thereof.

Moreover, all statements herein reciting principles, aspects, and implementations of the present technology, as well as specific examples thereof, are intended to encompass both structural and functional equivalents thereof, whether they are currently known or developed in the future. Thus, for example, it will be appreciated by those skilled in the art that any block diagrams herein represent conceptual views of illustrative circuitry embodying the principles of the present technology. Similarly, it will be appreciated that any flowcharts, flow diagrams, state transition diagrams, pseudo-code, and the like represent various processes which may be substantially represented in computer-readable media and so executed by a computer or processor, whether or not such computer or processor is explicitly shown.

In the context of the present specification, when an element is referred to as an electronic device, the element may include but is not limited to: servers including blade servers; disk arrays/storage systems; storage area networks; network attached storage; storage communication systems; work stations; routers; telecommunication infrastructure/switches; wired, optical and wireless communication devices; cell processor devices; printers; power supplies; displays; optical devices; instrumentation systems including hand-held systems; military electronics; etc. Many of the concepts will be described and illustrated herein as applied to an array of computer servers. However, it is to be realized that the concepts described herein could be used on other electronic devices as well.

With these fundamentals in place, the instant disclosure is directed to address at least some of the deficiencies of the current technology. In particular, the instant disclosure describes a rack system for housing an electronic device.

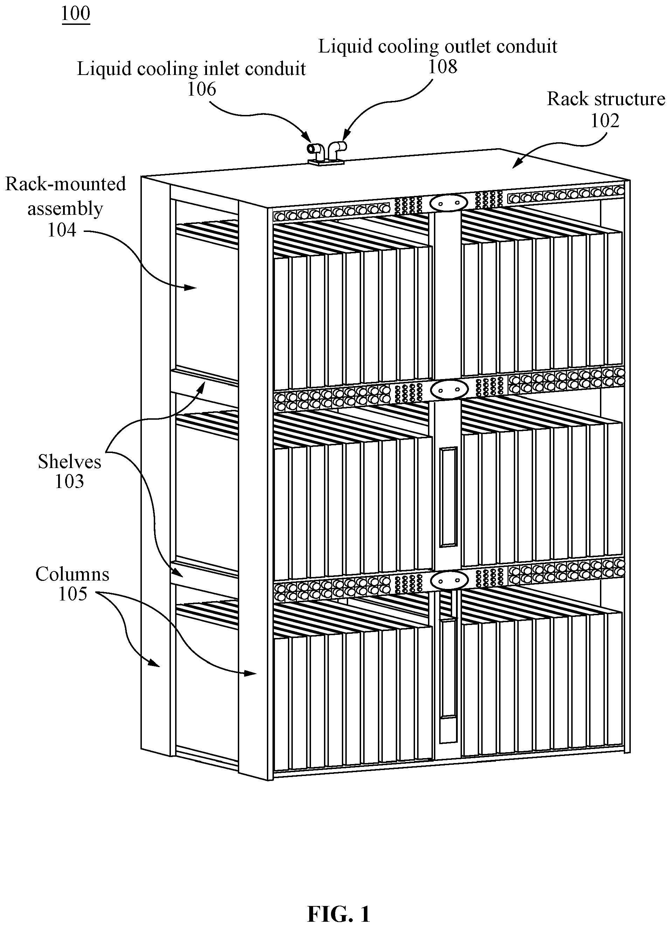

FIG. 1 illustrates a perspective view of a rack system **100** for housing a rack mounted assembly 104. As shown, the rack system **100** may include a rack structure **102,** a rack mounted assembly **104,** a liquid cooling inlet conduit **106** and a liquid cooling outlet conduit **108.**

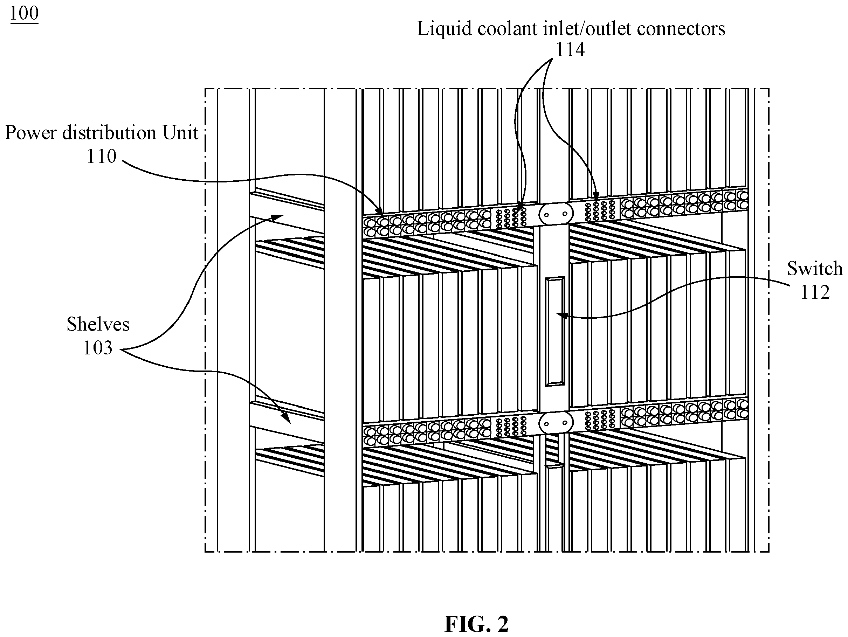

FIG. 2 illustrates another perspective view of the rack system 100. As shown, the rack system **100** may further comprise a power distribution unit **110,** a switch **112,** and liquid coolant inlet/outlet connectors **114.** It is to be noted that the rack system **100** may include other components such as heat exchangers, cables, pumps or the like, however, such components have been omitted from FIGs. 1 and 2 for the purpose of simplicity. As shown in FIGs. 1 and 2, the rack structure **102** may include shelves **103** to slidably accommodate racking and de-racking of one or more rack-mounted assemblies **104.** In certain non-limiting examples, the one or more rack mounted assemblies **104** may be racked vertically on the shelves **103.**

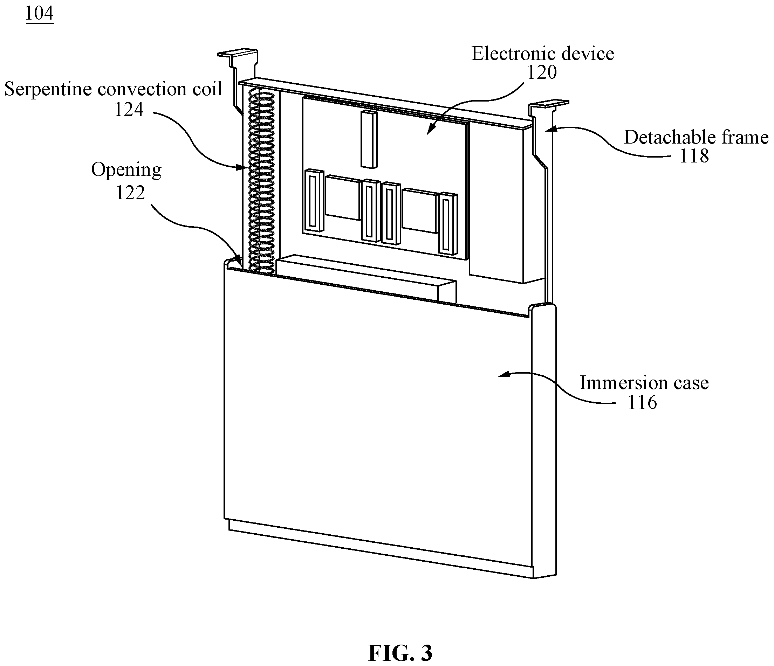

FIG. 3 illustrates a perspective view of the rack mounted assembly 104. As shown, the rack mounted assembly **104** may include an immersion case **116** and a detachable frame **118.** The detachable frame **118** may hold an electronic device **120** and may be immersed in the immersion case **116.**

It is contemplated that the electronic device **120** may generate a significant amount of heat. To this end, the rack system **100** may use a mechanism to cool down the electronic device **120** to prevent the electronic device **120** from getting damaged. To do so, in certain non-limiting examples, an immersion cooling liquid may be inserted in the immersion case **116.** Further, the detachable frame **118** including the electronic device **120** may be immersed in the immersion case **116.** In certain non-limiting examples, the immersion cooling liquid and the detachable frame **118** may be inserted to the immersion case **116** *via* an opening **122** at the top of the immersion case **116.** In certain non-limiting examples, the detachable frame **118** may be attached in a non-sealed configuration to the immersion case **116.**

In certain non-limiting examples, the immersion cooling liquid may be dielectric immersion cooling liquid. All the electronic and thermally active components associated with the electronic device **120** may be immersed in the dielectric immersion cooling liquid. The dielectric cooling liquid may be in direct contact with the electronic and thermally active components associated with the electronic device **120.** Thus, the immersion case **116** may act as a container containing the electronic device **120** and the dielectric immersion cooling liquid. The dielectric immersion cooling liquid may cool the electronic device **120.**

The dielectric immersion cooling liquid that may be used in various examples may include but are not limited to Fluorinert^{™} FC-3283, Fluorinert^{™} FC-43, Silicone oil 20, Silicone oil 50, Sobyean oil, S5 X (Shell), SmartCoolant (Submer), ThermaSafe R^{™} (Engineered fluids), Novec^{™}-7100 or the like. It is to be noted that any suitable dielectric immersion cooling may be employed in various non-limiting examples, provided the dielectric immersion cooling liquid is capable of providing insulation among various electronic and thermally active components associated with the electronic device **120** along with a capability of cooling the components.

In certain non-limiting examples, the immersion case **116** may also include a convection inducing structure to cool/induce convection in the dielectric immersion cooling liquid. By way of a non-limiting example, the convection inducing structure may be a serpentine convection coil **124** attached to the detachable frame **118.** The serpentine convection coil **124** may be fluidly coupled to the liquid cooling inlet conduit **106** and the liquid cooling outlet conduit **108** *via* the liquid coolant inlet/outlet connectors **114.** The serpentine convection coil **124** may allow a flow of a circulating cooling liquid. The circulating cooling liquid, by means of convection, may cool down the dielectric immersion cooling system. Thereby, making the cooling mechanism of the electronic device **120** a hybrid cooling mechanism.

Further, the electronic device **120** may be connected to the power distribution unit **110** and the switch **112** *via* power and network cables (not illustrated) to facilitate powering the electronic device **120** and to facilitate communication between the electronic device **120** and external devices (not illustrated) through the switch **112.**

As previously noted that the dielectric immersion cooling liquid may be inserted in the immersion case **116** for cooling the electronic device **120** and the immersion case **116** may be vertically racked in the rack structure **102.** There may be instances where the immersion case **116** is removed from the rack structure **102,** for example for maintenance purposes. To this end there are chances that the dielectric immersion cooling liquid may be spilled out of the immersion case **116** causing a wastage of at least a part of the dielectric immersion cooling liquid. This may result in a monetary loss as the dielectric immersion cooling liquid is quite expensive to procure and use, with possible negative environmental consequences.

With this said, there is interest in designing an effective immersion cases for the rack structure **102** that may allow a removal of at least a part of the dielectric immersion cooling liquid while preventing the dielectric immersion cooling liquid from spilling out of the immersion case **116.** In certain non-limiting examples, the removed dielectric immersion cooling liquid may be reused by returned to the immersion case **116** during a racking operation of the immersion case **116** to the rack structure **102.**

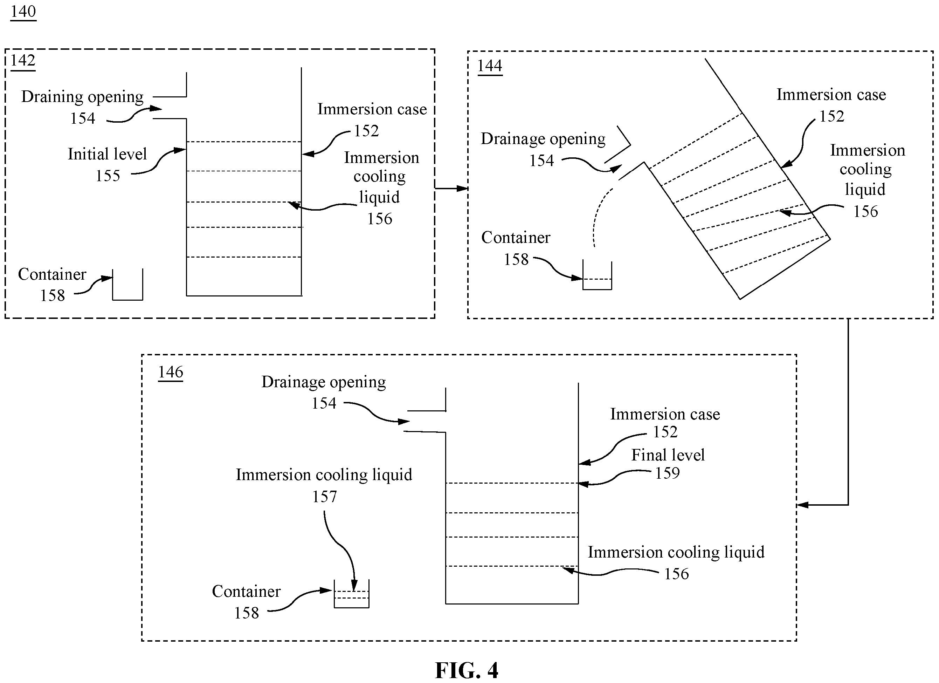

FIG. 4 illustrates a process **140** for removing at least a part of a dielectric immersion cooling liquid **156** from an immersion case **152,** in accordance with various non-limiting examples of the present disclosure. As shown, the process **140** commences at operation **142** where a container **158** is placed near the immersion case **152** including the dielectric immersion cooling liquid **156** and the electronic device **120** (shown on FIG. 3). The dielectric immersion cooling liquid **156** may have an initial level **155** in the immersion case **152.** Further, the immersion case **152** may already be racked in the rack structure 102. In certain non-liming examples, the immersion case **152** may include a drainage opening **154.**

The process **140** may proceed to the operation **144** where, based on a user actuated action, the drainage opening 154 removes at least a part of the dielectric immersion cooling liquid **156** during the de-racking operation of the immersion case **152** from the rack structure **102.** In certain non-limiting examples, the de-racking operation may be understood as including a plurality of operations including, for example and limitation, sliding of the immersion case **152,** pivoting of the immersion case **152,** removal of the immersion case **152** from the rack structure **102.**

As a result of the user actuated action (details of which will be discussed later in the disclosure), the immersion case **152** may pivot (*e.g.,* tilt, rotate or move) in such a manner that some of the dielectric immersion cooling liquid **156** may be drained out from the drainage opening **154** and may be collected in the container **158.**

The process **140** may proceed to operation **146** where, a level of the dielectric immersion cooling liquid **156** in the immersion case **152** being now lower than in operation **142** and is represented as final level **159.** The immersion case **152** may be brought back to original orientation and may be de-racked from the rack structure **102** without spilling out the dielectric immersion cooling liquid **156.** The container **158** may contain dielectric immersion cooling liquid **157** removed from the immersion case **152.** In certain non-limiting examples, the dielectric immersion cooling liquid **157** may be returned to the immersion case **152** during the racking operation.

In certain non-liming examples, the immersion case **152** may be open from the top from where the dielectric immersion cooling liquid **156, 157** and the detachable frame **118** holding the electronic device **120** may be inserted in the immersion case.

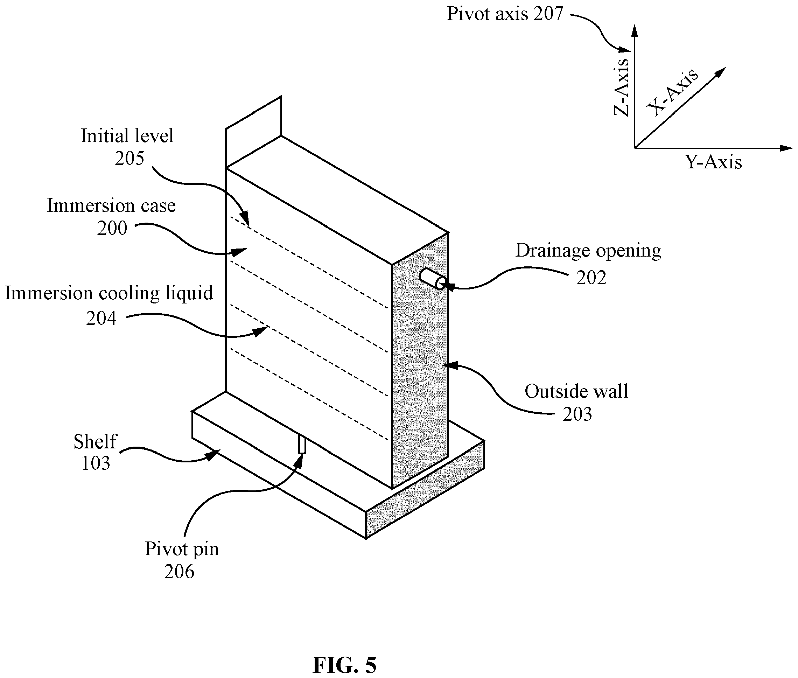

FIGs. 5-9 illustrate perspective views of various non-limiting examples corresponding to the removal of dielectric immersion cooling liquid **204** from an immersion case **200** during the de-racking of the immersion case **200** from the rack structure **102.**

Prior to discussing the various non-limiting examples as represented by FIGs. 5-9, it is to be noted that the immersion case **152** and the dielectric immersion cooling liquid **156** and **157** previously discussed in FIG. 4 may be similar to the immersion case **200** and the dielectric immersion cooling liquid **204.** However, for the purpose of simplicity, the immersion case **200** and the dielectric immersion cooling liquid **204** have been referred with different numerals.

Referring to FIG. 5, in certain non-limiting examples, the immersion case **200** may include the dielectric immersion cooling liquid **204** and the electronic device **120** (shown on FIG. 3). The immersion case **200** may include a drainage opening **202.** In certain non-limiting examples, the drainage opening **202** may be located near the top of an outside wall **203** of immersion case **200,** the outside wall **203** being exposed on the front side of the rack structure **102.** In certain non-liming examples, the drainage opening **202** may be located near the middle of the outside wall **203** of immersion case **200.** In other non-limiting examples, the drainage opening **202** may be located in near the bottom of the outside wall **203** of immersion case **200.** It is to be noted that examples where the drainage opening **202** is located on the outside wall **203** of the immersion case **200** do not limit the scope or present disclosure.

In certain non-limiting examples, the immersion case **200** may be removably coupled to a pivot pin **206** In certain non-limiting examples, the pivot pin **206** may be embedded in the shelf **103** of the rack structure **102.** The pivot pin **206** may have a pivot axis **207,** the pivot axis **207** being generally oriented along a vertical aspect of the rack structure **102.**

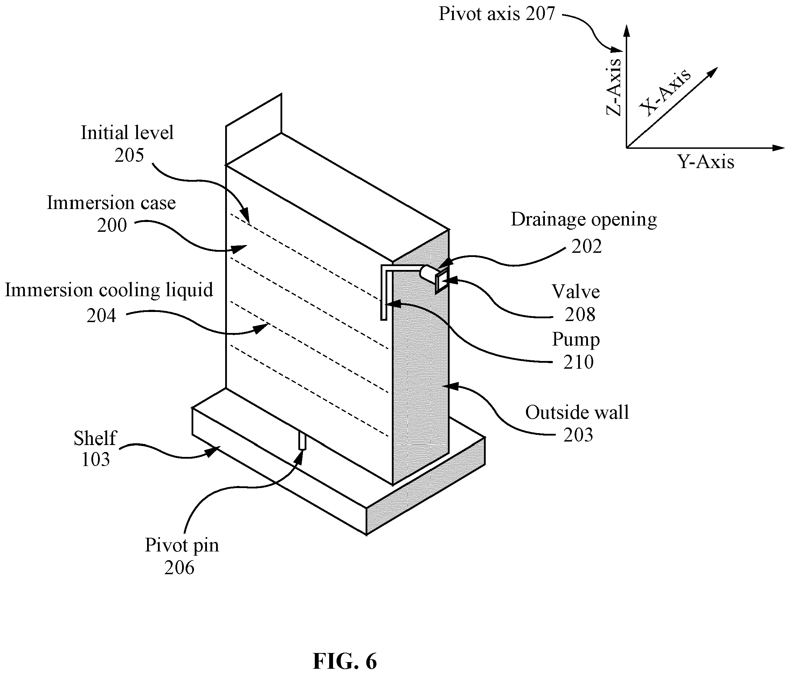

Referring to FIG. 6, in certain non-limiting examples, the drainage opening **202** may be a liquid-proof closing configured to be openable and closable, based on a user actuated action, such that, when the liquid-proof openable closing is opened, resulting from the user actuated action during the de-racking operation, the liquid-proof openable closing may allow the removal of at least a part of the dielectric immersion cooling liquid **204** from the immersion case **200.** In certain non-limiting examples, the liquid-proof openable closing may include a valve **208** such that when the valve **208** may be opened by the user (*i.e.,* user actuated action), the drainage opening **202** may allow at least a portion of the dielectric immersion cooling liquid **204** to be removed from the immersion case **200.**

Further, in certain non-limiting examples, in addition to or alternatively, the immersion case **200** may further include a pump **210** coupled to the drainage opening **202.** The pump **210** may pump out at least a part of the dielectric immersion cooling liquid **204** from the immersion case **200.**

In certain non-limiting examples, resulting from the user actuated action, the immersion case **200** may pivot about the pivot axis **207** associated with the pivot pin **206** so that the top of the outside wall **203** protrudes from a face of the rack structure **102,** in such a manner that the drainage opening **202** is lowered below the initial level **205** of the dielectric immersion cooling liquid **204** to allow removal of at least a part of the dielectric immersion cooling liquid **204** from the immersion case **200** during the de-racking operation.

In certain non-limiting examples, the immersion case **200** may be manually pivotable about the pivot axis **207.** In other words, the user may manually pivot the immersion case **200** to remove the dielectric immersion cooling liquid **204** from the immersion case **200.**

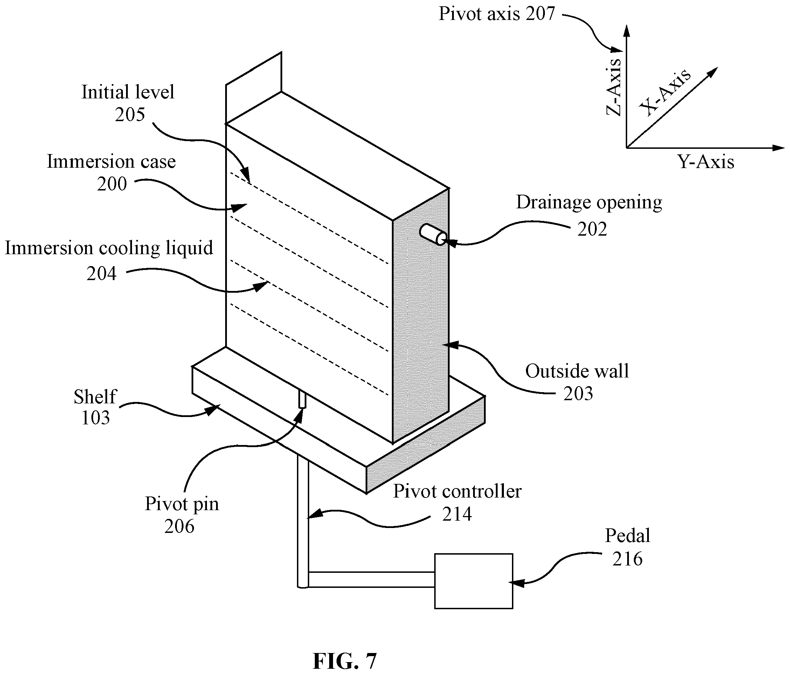

In certain non-limiting examples, the immersion case **200** may be mechanically pivotable about the pivot axis **207** associated with the pivot pin **206.** Referring to FIG. 7, in certain non-limiting examples, the pivot pin **206** may be coupled a pedal **216** *via* a pivot controller **214** (*e.g.,* a lever assembly or the like). In some of the non-limiting examples the pedal **216** may be located at the bottom of the rack structure **102.** In other non-liming examples, the pedal **216** may be located at columns **105** (as shown in FIG. 1) of the rack structure **102.** It is to be noted that the location of the pedal **216** should not limit the scope of present disclosure.

Based on the user actuated actions, for example pressing of the pedal **216,** the pivot controller **214** may cause the pivot pin **206** to pivot, resulting in pivoting of the immersion case **200.** In so doing, the dielectric immersion cooling liquid **204** may be drained out at least in part from the drainage opening **202.** In certain non-limiting examples, the immersion case **200** may remain pivoted as long as the pedal **216** is being pressed by the user. In other non-limiting examples, the user may press the pedal **216** once and the immersion case **200** may remain pivoted and, resulting from a second user actuated action, for example pressing again the pedal **216,** the immersion case **200** may return to its original position.

It is to be noted that the mechanical structure including the pedal **216** to pivot the immersion case **200** may be one non-limiting example of the present disclosure. In one non-limiting example, the shelf **103** may define a cavity or a stopper onto which the immersion case **200** may be racked in such a manner that the immersion case **200** may be pivoted to remove at least a portion of the dielectric immersion cooling liquid **204.** In another non-limiting example, a handle may be coupled to the outside wall **203** of the immersion case **200** such that the handle may assist the user to pivot the immersion case **200.**

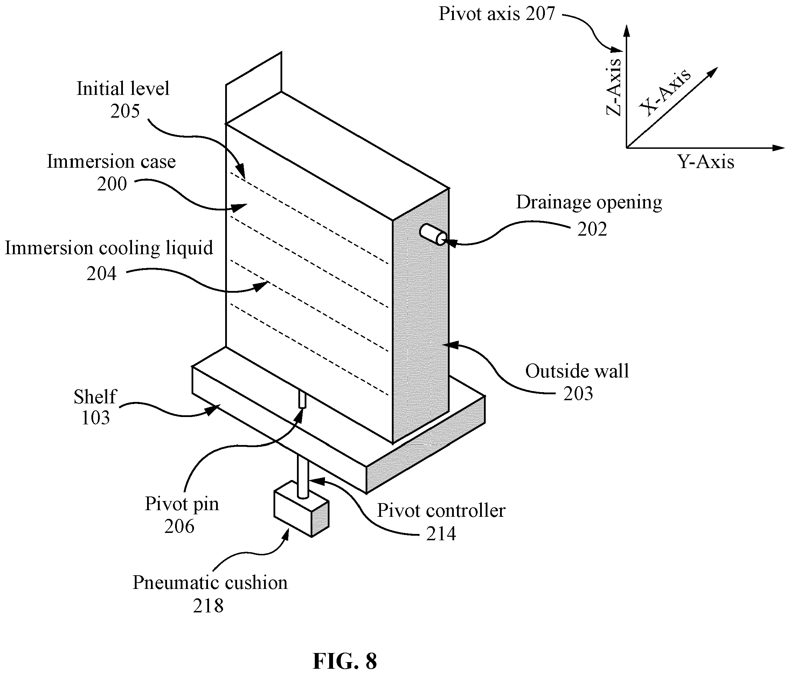

In certain non-limiting examples, the immersion case **200** may be pneumatically pivotable about the pivot axis **207** associated with the pivot pin **206.** Referring to FIG. 8, in certain non-limiting examples, the pivot pin **206** may be coupled to a pneumatic cushion **218** *via* the pivot controller **214** (*e.g.,* a pneumatic tube or the like). In some of the non-limiting examples, the pneumatic cushion **218** may be located below the shelf **103** of the rack structure **102** where the immersion case **200** is located. In other non-liming examples, the pneumatic cushion **218** may be located at some other location in the rack structure **102.** It is to be noted that the location of the pneumatic cushion **218** does not limit the scope of present disclosure.

Resulting from the user actuated actions, for example actuating pneumatic cushion **218,** the pivot controller **214** may pivot the pivot pin **206** resulting in pivoting of the immersion case **200.** In so doing, the dielectric immersion cooling liquid **204** may be drained out at least in part from the drainage opening **202.** In certain non-limiting examples, the immersion case **200** may remain pivoted as long as the pneumatic cushion **218** is being actuated by the user. In other non-limiting examples, the user may actuate the pedal **216** once and the immersion case **200** may remain pivoted and, resulting from a second user actuated action, for example again actuating the pneumatic cushion **218,** the immersion case **200** may return to its original position.

It is to be noted that the pneumatic structure including the pneumatic cushion **218** to pivot the immersion case **200** may be one non-limiting example of the present disclosure. Various other pneumatic structures, such as for example, a, hook, cables, a pulley, or the like may be used to pivot the immersion case **200.**

In certain non-liming examples, irrespective of the pivoting mechanism (*e.g*., manual, mechanical, or pneumatic), the immersion case **200** may pivot between 0 to 45 degrees about the pivot axis **207.**

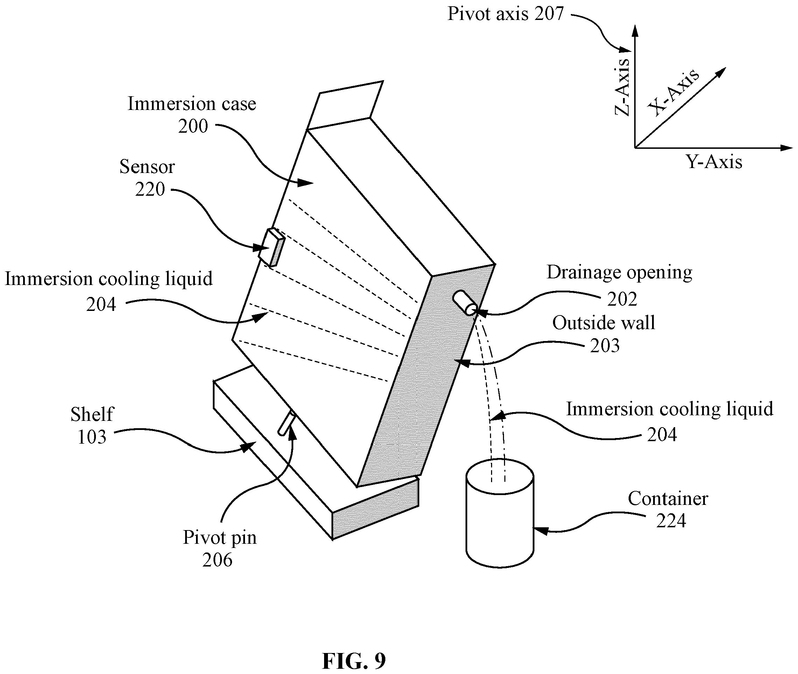

FIG. 9 illustrates a perspective view of the immersion case **200** being pivoted to remove at least a part of the dielectric immersion cooling liquid **204.** As shown, the immersion case **200** may be pivoted around the pivot axis **207** resulting from the user actuated action (as previously discussed).

In certain non-limiting examples, the immersion case **200** may include a sensor **220** to determine and indicate a level of the dielectric immersion cooling liquid **204** in the immersion case **200.** In certain non-limiting examples, the sensor **220** may be a float sensor. In other non-limiting examples, the sensor **220** may be an optical sensor positioned in view of a transparent window (not shown) formed on a side of the immersion case **200.** In certain non-limiting examples, the sensor **220** may output an audio, visual or both the audio and visual indication about the level of dielectric immersion cooling liquid **204.** The indication from the sensor **220** may assist the user to determine that a sufficient part of the dielectric immersion cooling liquid **204** has been removed from the immersion case **200** and that the immersion case **200** may be de-racked from the rack structure **102** without spilling out the dielectric immersion cooling liquid **204.** Sending a signal from the sensor **220** to an external monitoring device (not shown) is also contemplated.

In certain non-limiting examples, the dielectric immersion cooling liquid **204** may be collected in a container **224.** In certain non-limiting examples, the dielectric immersion cooling liquid **204** collected in the container **224** may be inserted back to the immersion case **200** during the racking operation.

Thus, by virtue of the immersion case **200** including the drainage opening **202** may provide an efficient mechanism to remove the dielectric immersion cooling liquid **204** from the immersion case **200** prior to de-racking. Thereby, preventing the dielectric immersion cooling liquid **204** from spilling out of the immersion case **200.**

## Claims

1. A rack system **(100)** for housing an electronic device **(120),** comprising:
an immersion case **(200)** configured to provide housing to the electronic device **(120),** and to receive an immersion cooling liquid **(204),** wherein the immersion case **(200)** includes a drainage opening **(202),** wherein:
the drainage opening **(202)** is configured to remove at least a part of the immersion cooling liquid **(204)** from the immersion case **(200),** based on a user actuated action, during a de-racking operation of the immersion case **(200);** and
a rack frame **(102)** configured to slidably accommodate racking and de-racking operations of the immersion case **(200);**
**characterized in that**:
the drainage opening **(202)** is located near a top of the immersion case **(200),**
the immersion case **(200)** is coupled to a pivot pin **(206),**
a pivot axis **(207)** is associated with a position of the pivot pin **(206)** when the immersion case **(200)** is racked in the rack frame **(102),**
the immersion case **(200)** is further configured to tilt away from the pivot axis **(207)** upon the user actuated action, and
tilting of the immersion case **(200)** during the de-racking operation allows removal of at least a part of the immersion cooling liquid **(204)** from the immersion case **(200)** via the drainage opening **(202).**

2. The rack system **(100)** of claim 1, wherein the drainage opening **(202)** is configured to be openable and closable such that, when the drainage opening **(202)** is opened, based on the user actuated action, the drainage opening **(202)** allows removal of at least a part of the immersion cooling liquid **(204)** from the immersion case **(200)** during the de-racking operation, and such that the drainage opening **(202)** is liquid-proof when closed.

3. The rack system **(100)** of claim 1 or 2, wherein the drainage opening **(202)** further comprises one or more of a valve **(208)** and a pump **(210)** to remove at least a part of the immersion cooling liquid **(204).**

4. The rack system **(100)** of any one of claims 1 to 3, wherein the immersion case **(200)** is manually pivotable about the pivot axis **(207).**

5. The rack system **(100)** of any one of claims 1 to 4 wherein the immersion case **(200)** is mechanically pivotable about the pivot axis **(207).**

6. The rack system **(100)** of claim 5, wherein the pivot pin **(206)** is coupled to a pedal **(216)** and the pedal **(216)** causes the immersion case to mechanically pivot about the pivot axis **(207).**

7. The rack system **(100)** of any one of claims 1 to 4, wherein the immersion case **(200)** is pneumatically pivotable about the pivot axis **(207).**

8. The rack system **(100)** of claim 7, wherein the pivot pin **(206)** is coupled at a pneumatic cushion and the pneumatic cushion **(218)** causes the immersion case to pneumatically pivot about the pivot axis **(207).**

9. The rack system **(100)** of any one of claims 1 to 8, wherein the immersion case is configured to pivot between 0 to 45 degrees about the pivot axis **(207).**

10. The rack system **(100)** of any one of claims 1 to 9, wherein the immersion case **(200)** further includes a sensor **(220)** configured to determine and indicate a level of the immersion cooling liquid **(204)** in the immersion case **(200).**

11. The rack system **(100)** of any one of claims 1 to 10, wherein the immersion cooling liquid **(204)** is a dielectric immersion cooling liquid.

12. The rack system of any one of claims 1 to 11, wherein the immersion case **(200)** is stacked vertically in the rack frame **(102).**

## Patentansprüche

1. Racksystem **(100)** zur Aufnahme einer elektronischen Vorrichtung **(120),** umfassend:
einen Tauchbehälter **(200),** der dazu konfiguriert ist, ein Gehäuse für die elektronische Vorrichtung **(120)** bereitzustellen und eine Tauchkühlflüssigkeit **(204)** aufzunehmen, wobei das Tauchgehäuse **(200)** eine Abflussöffnung **(202)** beinhaltet, wobei:
die Abflussöffnung **(202)** dazu konfiguriert ist, zumindest einen Teil der Tauchkühlflüssigkeit **(204)** aus dem Tauchbehälter **(200)** basierend auf einer durch einen Benutzer ausgeführten Handlung während eines Entnahmevorgangs des Tauchbehälters **(200)** zu entfernen; und
einen Rack-Rahmen **(102),** der dazu konfiguriert ist, gleitbar Einsatz- und Entnahmevorgänge des Tauchbehälters **(200)** zu ermöglichen;
**dadurch gekennzeichnet, dass**:
die Abflussöffnung **(202)** sich nahe einer Oberseite des Tauchbehälters **(200)** befindet,
der Tauchbehälter **(200)** mit einem Drehzapfen **(206)** gekoppelt ist,
eine Drehachse **(207)** mit einer Position des Drehzapfens **(206)** assoziiert ist, wenn der Tauchbehälter **(200)** in das Rack **(102)** eingesetzt ist,
der Tauchbehälter **(200)** ferner dazu konfiguriert ist, sich bei einer durch einen Benutzer ausgeführten Handlung von der Drehachse **(207)** weg zu neigen, und
Neigen des Tauchbehälters **(200)** während des Entnahmevorgangs eine Entfernung zumindest eines Teils der Tauchkühlflüssigkeit **(204)** aus dem Tauchbehälter **(200)** über die Abflussöffnung **(202)** ermöglicht.

2. Racksystem **(100)** nach Anspruch 1, wobei die Abflussöffnung **(202)** dazu konfiguriert ist, öffenbar und schließbar zu sein, so dass, wenn die Abflussöffnung **(202)** geöffnet ist, basierend auf der durch einen Benutzer ausgeführten Handlung, die Abflussöffnung **(202)** eine Entfernung zumindest eines Teils der Tauchkühlflüssigkeit **(204)** aus dem Tauchbehälter **(200)** während des Entnahmevorgangs ermöglicht und so dass die Abflussöffnung **(202)** flüssigkeitsdicht ist, wenn sie geschlossen ist.

3. Racksystem **(100)** nach Anspruch 1 oder 2, wobei die Abflussöffnung **(202)** ferner einen oder mehrere von einem Ventil **(208)** und einer Pumpe **(210)** umfasst, um zumindest einen Teil der Tauchkühlflüssigkeit **(204)** zu entfernen.

4. Racksystem **(100)** nach einem der Ansprüche 1 bis 3, wobei der Tauchbehälter **(200)** manuell um die Drehachse **(207)** drehbar ist.

5. Racksystem **(100)** nach einem der Ansprüche 1 bis 4, wobei der Tauchbehälter **(200)** mechanisch um die Drehachse **(207)** drehbar ist.

6. Racksystem **(100)** nach Anspruch 5, wobei der Drehzapfen **(206)** mit einem Pedal **(216)** gekoppelt ist und das Pedal **(216)** den Tauchbehälter dazu veranlasst, sich mechanisch um die Drehachse **(207)** zu drehen.

7. Racksystem **(100)** nach einem der Ansprüche 1 bis 4, wobei der Tauchbehälter **(200)** pneumatisch um die Drehachse **(207)** drehbar ist.

8. Racksystem **(100)** nach Anspruch 7, wobei der Drehzapfen **(206)** an ein pneumatisches Polster gekoppelt ist und das pneumatische Polster **(218)** den Tauchbehälter dazu veranlasst, sich pneumatisch um die Drehachse **(207)** zu drehen.

9. Racksystem **(100)** nach einem der Ansprüche 1 bis 8, wobei der Tauchbehälter dazu konfiguriert ist, sich zwischen 0 bis 45 Grad um die Drehachse **(207)** zu drehen.

10. Racksystem **(100)** nach einem der Ansprüche 1 bis 9, wobei der Tauchbehälter **(200)** ferner einen Sensor **(220)** beinhaltet, der dazu konfiguriert ist, einen Pegel der Tauchkühlflüssigkeit **(204)** in dem Tauchbehälter **(200)** zu bestimmen und anzuzeigen.

11. Racksystem **(100)** nach einem der Ansprüche 1 bis 10, wobei die Tauchkühlflüssigkeit **(204)** eine dielektrische Tauchkühlflüssigkeit ist.

12. Racksystem nach einem der Ansprüche 1 bis 11, wobei der Tauchbehälter **(200)** vertikal in dem Rack-Rahmen **(102)** gestapelt ist.

## Revendications

1. Système de rayonnage **(100)** pour loger un dispositif électronique **(120),** comprenant :
un boîtier d'immersion **(200)** conçu pour fournir un logement au dispositif électronique **(120),** et pour recevoir un liquide de refroidissement par immersion **(204),** dans lequel le boîtier d'immersion **(200)** comporte une ouverture de drainage **(202),**
dans lequel :
l'ouverture de drainage **(202)** est conçue pour retirer au moins une partie du liquide de refroidissement par immersion **(204)** du boîtier d'immersion **(200),** sur la base d'une action actionnée par l'utilisateur, pendant une opération de dérayonnage du boîtier d'immersion **(200)** ; et
un cadre de rayonnage **(102)** conçu pour recevoir de manière coulissante des opérations de rayonnage et de dérayonnage du boîtier d'immersion **(200)** ;
**caractérisé en ce que** :
l'ouverture de drainage **(202)** est située à proximité d'une partie supérieure du boîtier d'immersion **(200),**
le boîtier d'immersion **(200)** est couplé à un axe de pivotement **(206)**,
un axe de pivotement **(207)** est associé à une position de l'axe de pivotement **(206)** lorsque le boîtier d'immersion **(200)** est rangé dans le cadre de rayonnage **(102),**
le boîtier d'immersion **(200)** est en outre conçu pour s'incliner à l'opposé de l'axe de pivotement **(207)** lors de l'action actionnée par l'utilisateur, et
l'inclinaison du boîtier d'immersion **(200)** pendant l'opération de dérayonnage permet d'éliminer au moins une partie du liquide de refroidissement par immersion **(204)** du boîtier d'immersion **(200)** par l'intermédiaire de l'ouverture de drainage **(202).**

2. Système de rayonnage **(100)** selon la revendication 1, dans lequel l'ouverture de drainage **(202)** est conçue pour être ouverte et fermée de telle sorte que, lorsque l'ouverture de drainage **(202)** est ouverte, en fonction de l'action actionnée par l'utilisateur, l'ouverture de drainage **(202)** permet d'évacuer au moins une partie du liquide de refroidissement par immersion **(204)** du boîtier d'immersion **(200)** pendant l'opération de dérayonnage, et de telle sorte que l'ouverture de drainage **(202)** est étanche.

3. Système de rayonnage **(100)** selon la revendication 1 ou 2, dans lequel l'ouverture de drainage **(202)** comprend en outre une ou plusieurs d'une vanne **(208)** et d'une pompe **(210)** pour prélever au moins une partie du liquide de refroidissement par immersion **(204).**

4. Système de rayonnage **(100)** selon l'une quelconque des revendications 1 à 3, dans lequel le boîtier d'immersion **(200)** peut être pivoté manuellement autour de l'axe de pivotement **(207)** .

5. Système de rayonnage **(100)** selon l'une quelconque des revendications 1 à 4, dans lequel le boîtier d'immersion **(200)** peut être pivoté mécaniquement autour de l'axe de pivotement **(207)** .

6. Système de rayonnage **(100)** selon la revendication 5, dans lequel l'axe de pivotement **(206)** est couplé à une pédale **(216)** et la pédale **(216)** amène le boîtier d'immersion à pivoter mécaniquement autour de l'axe de pivotement **(207).**

7. Système de rayonnage **(100)** selon l'une quelconque des revendications 1 à 4, dans lequel le boîtier d'immersion **(200)** peut être pivoté pneumatiquement autour de l'axe de pivotement **(207)** .

8. Système de rayonnage **(100)** selon la revendication 7, dans lequel l'axe de pivotement **(206)** est couplé à un coussin pneumatique et le coussin pneumatique **(218)** amène le boîtier d'immersion à pivoter pneumatiquement autour de l'axe de pivotement **(207).**

9. Système de rayonnage **(100)** selon l'une quelconque des revendications 1 à 8, dans lequel le boîtier d'immersion est conçu pour pivoter entre 0 et 45 degrés autour de l'axe de pivotement **(207).**

10. Système de rayonnage **(100)** selon l'une quelconque des revendications 1 à 9, dans lequel le boîtier d'immersion **(200)** comporte en outre un capteur **(220)** conçu pour déterminer et indiquer un niveau du liquide de refroidissement par immersion **(204)** dans le boîtier d'immersion **(200).**

11. Système de rayonnage **(100)** selon l'une quelconque des revendications 1 à 10, dans lequel le liquide de refroidissement par immersion **(204)** est un liquide de refroidissement par immersion diélectrique.

12. Système de rayonnage selon l'une quelconque des revendications 1 à 11, dans lequel le boîtier d'immersion **(200)** est empilé verticalement dans le cadre de rayonnage **(102)** .
